# EUROPEAN PATENT SPECIFICATION

(11) **EP 0 487 993 B1**
(45) Date of publication and mention of the grant of the patent: **05.02.1997**
(21) Application number: 91119504.8
(22) Date of filing: 15.11.1991
(51) Int. Cl.: C08F 212/08, C08F 8/10, C08F 2/50, G03F 7/031

(54) **Stable liquid compositions useful as polymerization photopromoters, their preparation and use**
Stabile flüssige Zusammensetzungen zur Verwendung als Photopromotoren für die Polymerisation, ihre Herstellung und Verwendung
Stables compositions liquides utilisables comme photopromoteurs de polymérisation, leur préparation et leur utilisation

(30) Priority: 27.11.1990 IT 2219790
(43) Date of publication of application: 03.06.1992
(73) Proprietor: LAMBERTI S.p.A., 21041 Albizzate (Varese) (IT)
(72) Inventor: Li Bassi, Giuseppe, I-21026 Gavirate (Varese) (IT); Di Battista, Piero, I-20068 Peschiera Borromeo (Milan) (IT); Nicora, Carlo, I-21100 Varese (IT)
(74) Representative: Gervasi, Gemma, Dr.

(56) References cited:
- EP-A- 0 161 463
- US-A- 3 839 261
- US-A- 4 569 906
- US-A- 4 987 159

## Description

### A. Technical Backqround

The present invention refers to new stable liquid compositions suitable for use as photo-promoters for photo- polymerizing compounds or mixtures of compounds containing ethylenic double bonds, and their preparation and use.

The photo-chemical polymerization of unsaturated monomers and prepolymers is today a widely known process with a large number of industrial applications.

This type of reaction occurs due to the interaction between light energy in a well defined range of the electromagnetic spectrum, and a suitable substratum capable of absorbing the light and polymerizing. This irradiation causes, through various mechanisms depending on the nature of the substances present, the generation of radical type groups, which, within a very short time, give rise to a polymerisation reaction of the molecules containing ethylenic double bonds. To facilitate the absorbtion of light and the creation of radical groups, photo-sensitizing and photo-promoting substances in particular are generally used.

The photo-sensitizing substances are used to absorb and transfer luminous energy whenever a photo-promoter does not absorb energy in the spectrum regions useful for the photo-chemical reaction being carried out, the photo-promoters are used to generate radicals that promote polymerization.

The efficiency of these products has been steadily improved as technological processes using photo-polymerization have become more widespread, as in the case of paints and lacquers, printing inks, the manufacture of printing plates and electronic circuits, silk screens for printing on ceramics and textiles, transfers, and for use in dentistry The efficiency of these products is measured by their reactivity, intended both as quantum yield (the quantity of monomer converted for each quantum of light absorbed), as polymerization rate (the time required for a substrate to reach determined chemico/physical properties), and also the stablilty in the dark of mixtures containing a photo-promoter.

### B. Prior Art

1-Phenylindan type compounds with excellent photo-promoting properties are described by the same Applicant in Italian patent application 22477 A/87.

The physical form and tendency towards crystallization of the above compounds creates serious limitations in the preparation of liquid compositions that are stable in the long term. In the present text, the term "stable" signifies stable as to crystallization.

In pure form or in the conditions shown in Italian patent application 22477 A/87, the above compounds are crystalline or vitreous solids that, once dissolved, show at very high concentrations (30% to 80%), a more or less marked tendency to crystallize.

Italian Patent Application N. 22477/A87, granted on 19.09.1990 as Italian Patent No. 1223333, discloses solutions of some of the aforementioned 1-phenylindan type compounds in toluene and methylene chloride, obtained after repeated washings with water of the relative reaction mixtures. These solutions are then subjected to further reaction steps, or cooled to recover by crystallization the 1-phenylindan compound therein contained.

Other solid photo-promoters also tend to crystallize when one wants to prepare concentrated solutions to be added to mixtures to be photo-polymerized, and as a consequence photo-promoter substance based compositions have to be prepared immediately prior to use, and cannot be stored, or marketed either.

### C. The technical problem

1-Phenylindan type photo-promoting substances are solids or vitreous solids, thus it is necessary to prepare solutions to be added to polymerization mixtures.

These solutions are not stable in the long-term as they tend to sediment, and are thus prepared immediately prior to use. What is in fact required are long-term stable solutions that can be stored and marketed in a ready for use form, and are easy to dose and mix with photo-polymerization mixtures.

### D. Detailed Description of the Invention

The present invention refers to stable liquid compositions containing between 25 and 75 parts by weight of at least one solvent chosen from the group consisting of xylene, methylethyl ketone, butyl acetate, a possibly ethoxylated acrylic ester of a glycol or of a polyol, N-vinyl pyrrolidone, alphahydroxy isobutyrrophenone, a liquid benzophenone and diethoxyacetophenone, and containing between 25 and 75 parts by weight of at least one 1-phenylindan carbonyl derivative, whose structure is represented by the formula: 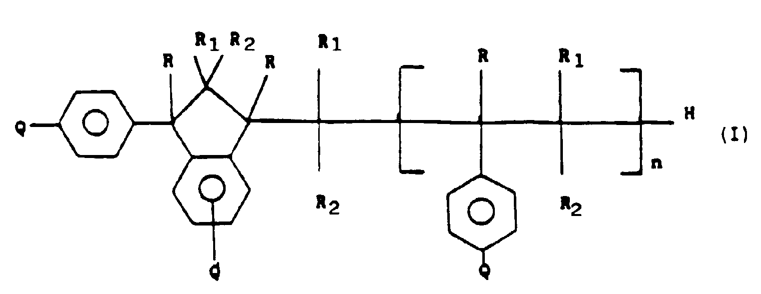 where:
n: from 0 to 1;
R, R₁, R₂: the same or different, each independently represent H, C₁-C₃ alkyl;
Q : represents a group 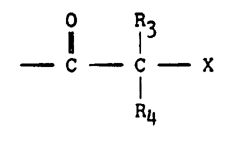 in which:
   R₃, R₄ the same or different, each can independently be:
   C₁-C₈ alkyl,

   - together they can be a C₃-C₇ polyalkylene group,
   - together they can coincide in an oxygen atom;
X : can be Cl, OH, OR in which R has the same meaning as before,

and to the process for their preparation and their use.

Favoured compositions contain between 30 and 70 parts by weight of derivatives of formula (I). Examples of liquid benzophenones are eutectics of 2,4,6-trimethylbenzophenone and 4-methylbenzophenone. Other preferred embodiments of the invention are disclosed in the dependent claims.

The derivatives of formula (I) are known, and are described, together with their general use characteristics in Italian patent application 22477 A/87.

In the above mentioned patent application, the derivatives of formula (I) are prepared by simultaneously cyclizing and oligomerizing styrene type derivatives, and then introducing them into carbonyl group molecules.

Surprisingly, it has been found that under particular conditions during the simultaneous cyclizing and oligomerizing stage of the initial styrene compound, by functionalizing the resulting compound without separating it from the reaction medium, and diluting the reaction mixtures with inert, reactive, or active diluents, the resulting liquid compositions on the basis of 1-phenylindan carbonyl derivatives of formula (I) are highly stable.

The mixtures of 1-phenylindan carbonyl derivatives thus obtained contain between 70% and 90% by weight of dimers with a formula (I), where n=0, the remaining part being trimers with formula (I), where n=₁.

According to a fundamental characteristic of the present invention, the stable liquid compounds that are the object of the invention are prepared by a process that includes the following essential stages:
A) Simultaneous cyclization and oligomerization of a styrene compound chosen from the group including styrene, alphamethylstyrene, styrene alpha substituted by C₂-C₄ alkyls and diphenylethylene, in the presence of an acid catalyst and in the absence of solvents, carried out in two stages: a first stage carried out at a temperature of 55° to 80°C for 1 to 3 hours, and a second stage at 120°C for 1 to 3 hours;
B) Introduction of carbonyl groups by Friedel-Crafts acylation, as described in the previous patent application EP 161463, by treating the mixture of oligomers resulting from stage A, dissolved in a solvent chosen from the group consisting of carbon sulphide, methylene chloride, dichloroethane, 1,1,1-trich!oroethane, and chloro-fluorohydrocarbons , or mixtures of them, with a solution in the same solvent of a complex between a carboxylic acid chloride and a Lewis acid catalyst at a temperature between -20°C and +20°C, followed by hydrolysis. washing with water, and evaporation of the solvent.
C) Diluticn of the resulting mixture of 1-phenylindan carbonyl derivatives by addition of at least one solvent chosen in the group consisting of xylene, methylethyl ketone, butyl acetate, a possibly ethoxylated acrylic ester of a glykol or of a polyol, N-vinyl pyrrolidone a-hydroxy isobutyrrophenone, a liquid benzophenone and diethoxy acethophe- none. The favoured acid catalysts for carrying out stage A of the process that is the object of the present invention are acid clays, ion exchange resins with sulphur groups in an acid form, and C₁-C₁₈-alkyl and C₆-C₁₈-aryl-sulphonic acids, among which those that are in an insoluble solid form are most favoured as they are easier to separate from the reaction mixture once oligomerization is completed.

The Lewis acid catalysts useful for stage B of the process according to the invention are, for example, AlCl₃, BF₃, SnCl₄, and TiCl₄.

The liquid compositions according to the present invention are efficient in promoting the photo-polymerization of unsaturated monomers and prepolymers just as the compositions prepared immediately prior to use by admixing the various components.

### EXAMPLE 1

The Preparation of the mixture of indan-phenyl-hydroxyketones from alpha-methylstyrene.

### A) Simultaneous Cyclization and Oligomerization in Two Staqes

10 g of alpha-methylstyrene and 4.3 g of Amberlyst® 15 (Rohm and Haass) were placed in a reactor with a bottom valve under stirring in a nitrogen atmosphere. The mixture was heated to 60°C, the temperature maintained at 60° + 5°C, and 420 g of alpha-methylstyrene were added over a period of 1 hour. The temperature (60° ±5°C) was maintained for a further hour, at the end of which the mixture was heated to 120°C (± 10°C), and held at that temperature for around 1 hour. The catalyst was separated from the base of the reactor by settling (in total, 4.3 g of Amberlyst@ 15 and 10 g of alpha- methylstyrene oligomers were separated, and recycled in the next process).

### B) Introduction of Carbonyl Groups

The mixture of oligomers (1) from stage A was diluted with 913 g methylene chloride. The resulting mixture was cooled to 20°C, and 813 g of alpha-bromo-isobutyrrylbromide were added.

493 g of anhydrous aluminium chloride were slowly added (without exceeding 20°C). The mixture was then heated to 40°C and held at that temperature for 3 hours.

The reaction mass was then poured into 1.8 1 of water, and once it had been completely dissolved by the addition of 640 g methylene chloride, the organic phase was separated from the aqueous phase, treated with 520 g of aqueous 50% solution of sodium hydroxide, and then heated to the boiling point for around two hours

The aqueous phase was then separated, and once the water had been removed and the organic phase had been clarified by filtering, the solvent was removed by vacuum distillation (50 mmHg) at a temperature of up to 60°C.

A mixture of 685 g of hydroxyketone oligomers (2) was thus obtained, ready for dilution in the most suitable solvent.

### C) Dilution

294 g of tripropyleneglycol diacrylate were then added, directly in the reactor, to the functionalized mixture of oligomers thus obtained.

The mixture was stirred until a homogenous mixture was obtained, and then poured into a container where it was left to cool to room temperature.

The resulting product was a viscous, clear, stable liquid that could be stored for months (at least 6).

### EXAMPLE 2

The chemical physical properties and the efficiency during application of the liquid composition obtained as described in Example 1 (composition a) were evaluated, as were those of a comparative liquid composition (composition b) obtained starting with alphamethylstyrene under conditions similar to those in Example 1, with the exception of the following aspects: Stage A was carried out in a single phase at 120°C; the product obtained from stages A and B was isolated before the successive stage; the dilution as described in stage C was carried out immediately prior to use.

The tests to evaluate the efficiency during the application of compositions a and b were conducted using the following resin formulation (all parts are by weight):

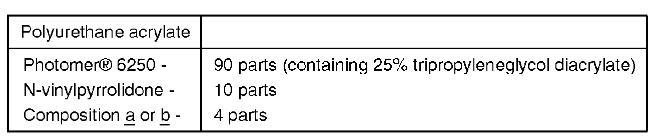

The chemical physical properties and the results of the efficiency tests are shown in table 1.

Descriptions of the application tests are given in the notes at the foot of Table 1.

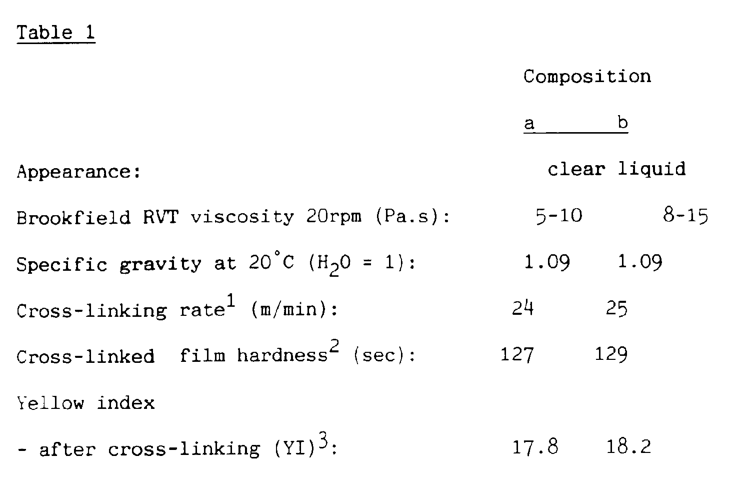

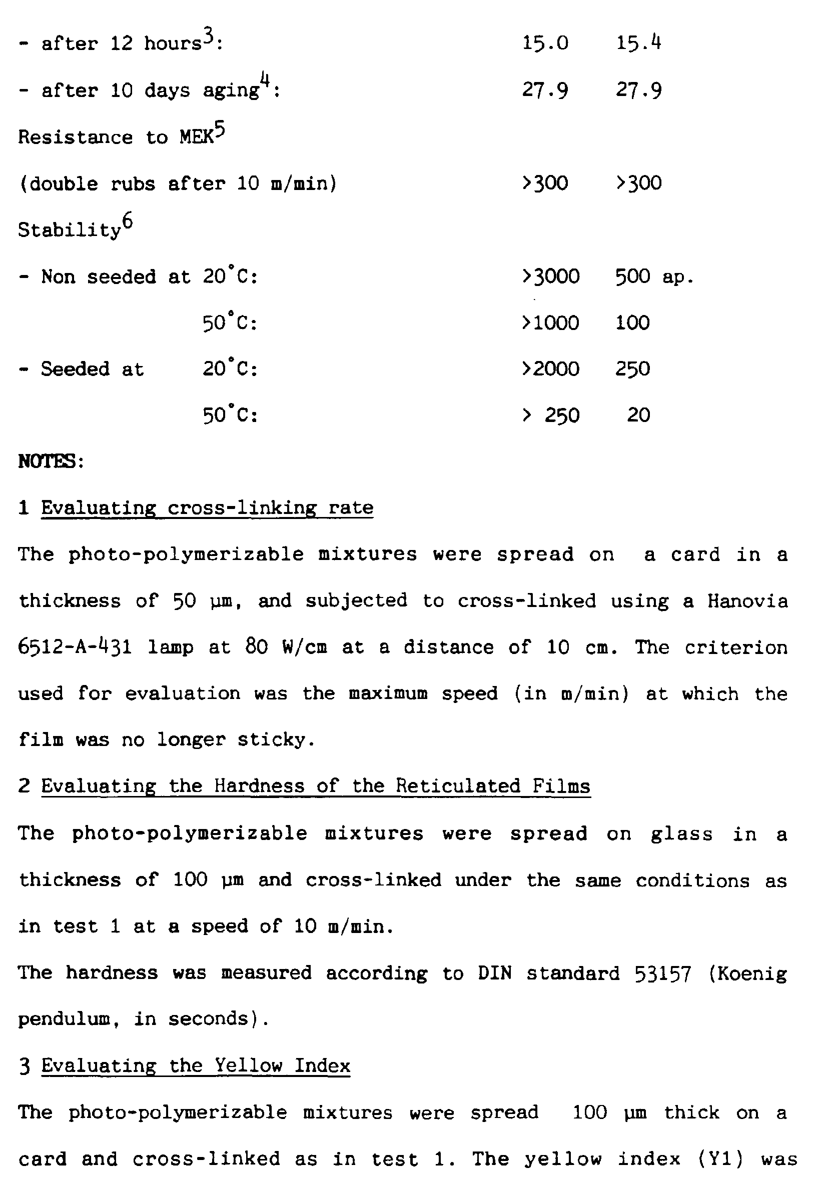

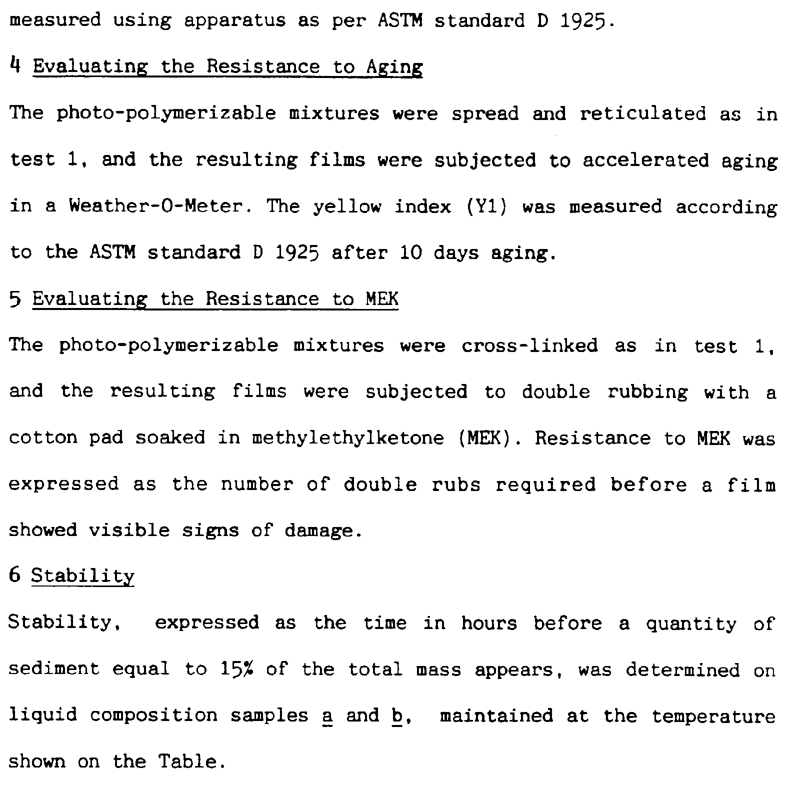

From the point of view of efficiency during application, no particular differences between compositions a and were detected. As far as their chemical/physical properties are concerned, composition a showed stability to crystallization, both when seeded and unseeded (crystalline germ), considerably higher than the composition b.

### EXAMPLE 3

A liquid composition was prepared as described in example 1, and evaluated as described in example 2 after being stored for 6 months. It then showed chemical/physical properties and efficiency during application that were entirely analogous to those of the composition in Example 1.

### EXAMPLE 4

70 parts of hydroxyketone oligomers (2) were prepared as described in example 1 a) and b), and were diluted as described in example 1 c) with 30 parts alphahydroxybutyrrophenone. The composition thus obtained was a clear liquid that was long-term stabler and had the following properties:

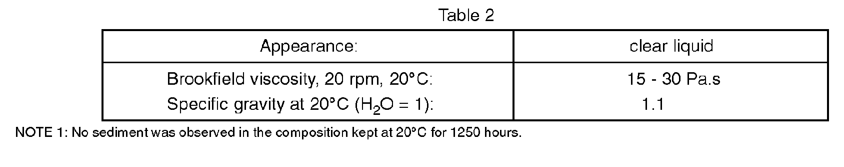

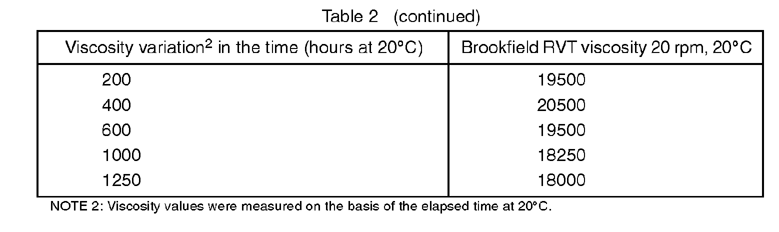

### EXAMPLE 5

70 parts of hydroxyketone oligomers (2) prepared as described in example 1 a) and b), were diluted as described in example 1 c) with 30 parts of an eutectic liquid composed of 80 parts 2,4,6-trimethylbenzophenone and 20 parts 4-methylbenzophenone. The composition thus obtained was a clear liquid that was stable for over 12 months at 20°C (appearance = clear liquid; Brookfield RVT viscosity at 20 rpm, 20°C = 1.5 - 3.5 Pa.s; Density at 20°C (H₂0 = 1) = 1.07; Pouring point = -5°C).

## Claims (Claims for the following Contracting State(s) : AT, BE, CH, LI, DE, FR, GB, NL, SE, IT)

1. Stable liquid compositions containing between 25 and 75 parts by weight of at least one solvent chosen from the group consisting of xylene, methylethyl ketone, butyl acetate, a possibly ethoxylated acrylic ester of a glycol or of a polyol, N-vinyl pyrrolidone, alphahydroxy isobutyrrophenone, a liquid benzophenone and diethoxyacetophenone, and containing between 25 and 75 parts by weight of at least one 1-phenylindan carbonyl derivative, whose structure is represented by the formula: 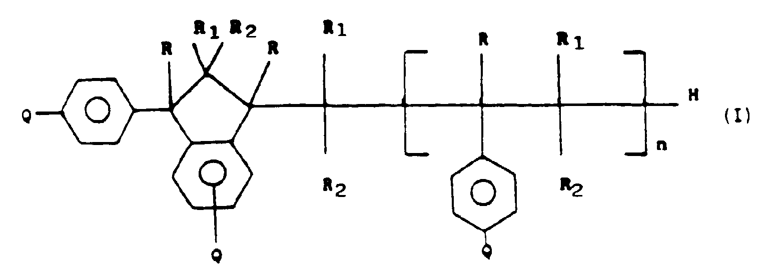 where:
n: from 0 to 1;
R, R₁, R₂ : the same or different, each independently represent H, C₁-C₃ alkyl;
Q : represents a group 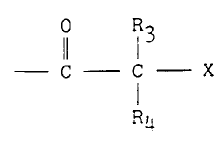 in which:
R₃, R₄ the same or different, each can independently be:
C₁-C₈ alkyl,
together they can be a C₃-C₇ polyalkylene group,
together they can coincide in an oxygen atom:
X : can be C1, OH, OR in which R has the same meaning as before

2. Stable liquid compositions as in Claim 1, containing between 30 and 70 parts by weight of the derivatives of formula (I).

3. Stable liquid compositions as in Claim 1, wherein the 1-phenylindan carbonyl derivative contains between 70% and 90% by weight of dimers of formula (I), where n=0, the remaining part being trimers of formula (I), where n=1.

4. Stable liquid compositions as in Claim 1, wherein the acrylic ester is selected from the group consisting of tripropyleneglycol diacrylate, hexandiol diacrylate, trimethylol propane ethoxylated acrylate, and bisphenol-A-ethoxylated acrylate.

5. Stable liquid compositions as in Claim 1, wherein the acrylic ester is tripropyleneglycol diacrylate.

6. Stable liquid compositions as in Claim 1, wherein the solvent is alphahydroxybutyrrophenone.

7. Stable liquid compositions as in Claim 1, wherein the liquid benzophenone is an eutectic liquid mixture of 80 parts 2,4,6-trimethylbenzophenone and 20 parts 4-methylbenzophenone.

8. Process for the preparation of liquid compositions as in Claim 1, comprising the following essential stages:
A) Simultaneous cyclization and oligomerization of a styrene compound chosen from the group consisting of styrene, alpha-methylstyrene, and styrene alpha-substituted by C₂-C₄ alkyls and diphenylethylene, in the presence of an acid catalyst and in the absence of solvents, carried out in two stages: a first stage carried out at a temperature of 55° to 80°C for 1 to 3 hours, and a second stage at 120°C for 1 to 3 hours;
B) introduction of carbonyl groups carried out by Friedel-Crafts acylation, by treating the mixture of oligomers resulting from stage A), dissolved in a solvent chosen from the group consisting of carbon sulphide, methylene chloride, dichloroethane, 1,1,1-trichloroethane, and chloro-fluoro hydrocarbons, or mixtures of them, with a solution in the same solvent of a complex between a carboxylic acid chloride and a Lewis acid catalyst at a temperature of between -20°C and +20°C, followed by hydrolysis, washing with water, and the evaporation of the solvent;
C) dilution of the resulting mixture of 1-phenylindan carbonyl derivatives by addition of at least one solvent chosen from the group consisting of xylene, methylethyl ketone, butyl acetate, a possibly ethoxylated acrylic ester of a glycol or of a polyol, N-vinyl pyrrolidone, alphahydroxy isobutyrrophenone. a liquid benzophenone and diethoxyacetophenone.

9. Process as in Claim 8, characterized in that the acid catalyst used to carry out stage A) is chosen from the group consisting of acid clays, ion exchange resins with sulphonic groups in acid form, and C₁-C₁₈ -alkyl-sulphonic and C₆-C₁₈ -aryl-sulphonic acids.

10. Process as in Claim 8, characterized in that the acid catalyst used in stage A) is in solid form.

## Claims (Claims for the following Contracting State(s) : ES)

1. Process for the preparation of stable liquid compositions containing between 25 and 75 parts by weight of at least one solvent chosen from the group consisting of xylene, methylethyl ketone, butyl acetate, a possibly ethoxylated acrylic ester of a glycol or of a polyol, N-vinyl pyrrclidone, alphahydroxy isobutyrrophenone, a liquid benzophenone and diethoxyacetophenone, and containing between 25 and 75 parts by weight of at least one 1-phenyindan carbonyl derivative, whose structure is represented by the formula: 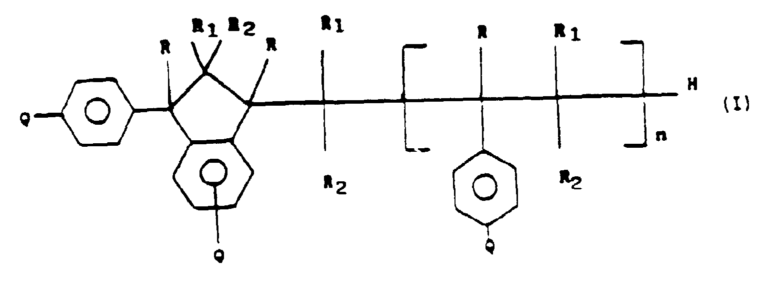 where:
n: from 0 to 1;
R, R₁, R₂ : the same or different, each independently represent H, C₁-C₃ alkyl;
Q : represents a group 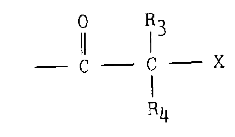 in which:
R₃, R₄ the same or different, each can independently be:
C₁-C₈ alkyl,
together they can be a C₃-C₇ polyalkylene group,
- together they can coincide in an oxygen atom;
X : can be Cl, OH, OR in which R has the same meaning as before, comprising the following essential stages:
A) Simultaneous cyclization and oligomerization of a styrene compound chosen from the group consisting of styrene, alpha-methylstyrene, and styrene alpha-substituted by C₂-C₄ alkyls and diphenylethylene, in the presence of an acid catalyst and in the absence of solvents, carried out in two stages: a first stage carried out at a temperature of 55° to 80°C for 1 to 3 hours, and a second stage at 120°C for 1 to 3 hours;
B) introduction of carbonyl groups carried out by Friedel-Crafts acylation, by treating the mixture of oligomers resulting from stage A), dissolved in a solvent chosen from the group consisting of carbon sulphide, methylene chloride, dichloroethane, 1,1,1-trichloroethane; and chloro-fluoro hydrocarbons, or mixtures of them, with a solution in the same solvent of a complex between a carboxylic acid chloride and a Lewis acid catalyst at a temperature of between -20°C and +20°C, followed by hydrolysis, washing with water, and the evaporation of the solvent;
C) dilution of the resulting mixture of 1-phenylindan carbonyl derivatives by addition of at least one solvent chosen from the group consisting of xylene, methylethyl ketone, butyl acetate, a possibly ethoxylated acrylic ester of a glycol or of a polyol, N-vinyl pyrrolidone, alphahydroxy isobutyrrophenone, a liquid benzophenone and diethoxyacetophenone.

2. Process as in Claim 1, characterized in that the acid catalyst used to carry out stage A) is chosen from the group consisting of acid clays, ion exchange resins with sulphonic groups in acid form, and C₁-C₁₈ -alkyl-sulphonic and C₆-C₁₈ -aryl-sulphonic acids.

3. Process as in Claim 1, characterized in that the acid catalyst used in stage A) is in solid form.

4. Process as in Claim 1, wherein the stable liquid compositions contain between 30 and 70 parts by weight of the derivatives of formula (I).

5. Process as in Claim 1, wherein the 1-phenylindan carbonyl derivative contains between 70% and 90% by weight of dimers of formula (I), where n=O, the remaining part being trimers of formula (I), where n=1.

6. Process as in Claim 1, wherein the acrylic ester is selected from the group consisting of tripropyleneglycol diacrylate, hexandiol diacrylate, trimethylol propane ethoxylated acrylate, and bisphenol-A-ethoxylated acrylate.

7. Process as in Claim 1, wherein the acrylic ester is tripropyleneglycol diacrylate.

8. Process as in Claim 1, wherein the solvent is alphahydroxybutyrrophenone.

9. Process as in Claim 1, wherein the liquid benzophenone is an eutectic liquid mixture of 80 parts 2,4,6-trimethylbenzophenone and 20 parts 4-methylbenzophenone.

## Patentansprüche (Patentansprüche für folgende(n) Vertragsstaat(en) : AT, BE, CH, LI, DE, FR, GB, SE, IT)

1. Stabile flüssige Zusammensetzungen, die zwischen 25 und 75 Gewichtsteile mindestens eines Lösungsmittels enthalten ausgewählt aus der Gruppe bestehend aus Xylol, Methylethylketon, Butylacetat, einem gegebenenfalls ethoxylierten Acrylester eines Glycols oder eines Polyols, N-Vinylpyrrolidon, a-Hydroxyisobutyrophenon, einem flüssigen Benzophenon und Diethoxyacetophenon, und zwischen 25 und 75 Gewichtsteile mindestens eines 1 -Phenylindancarbonyl-Derivats, dessen Struktur durch die Formel dargestellt wird: 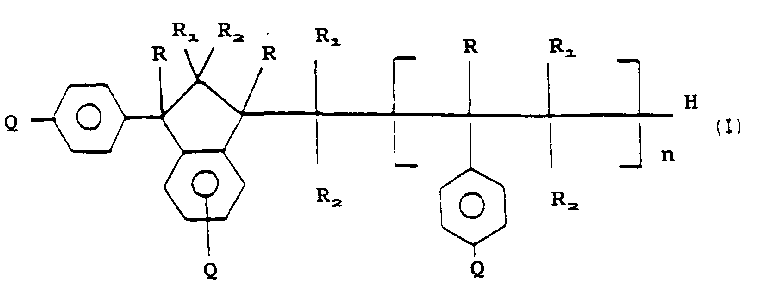 worin bedeuten:
n: 0 bis 1;
R, R_{1'} R₂: gleich oder verschiedene Reste, die unabhängig voneinander H, C₁-C₃-Alkyl bedeuten;
Q: eine Gruppe bedeutet 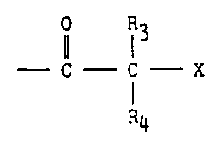 worin:
R₃, R₄ gleich oder verschieden sind und unabhängig voneinander bedeuten können:
- C₁-C₈-Alkyl,
- zusammen eine C₃-C₇-Polyalkylengruppe,
- zusammen genommen ein Sauerstoffatom;
X: kann bedeuten Cl, OH, OR, worin R die gleiche Bedeutung wie vorstehend angegeben besitzt.

2. Stabile flüssige Zusammensetzungen nach Anspruch 1, dadurch gekennzeichnet, daß sie zwischen 30 und 70 Gewichtsteile der Derivate der Formel (I) enthalten.

3. Stabile flüssige Zusammensetzungen nach Anspruch 1, dadurch gekennzeichnet, daß das I-Phenylindancarbonyl-Derivat zwischen 70 % und 90 Gew.-% Dimere der Formel (I), worin n=O, enthält, und der verbleibende Anteil aus Trimeren der Formel (I), worin n=₁, besteht.

4. Stabile flüssige Zusammensetzungen nach Anspruch 1, dadurch gekennzeichnet, daß der Acrylester ausgewählt ist aus der Gruppe bestehend aus Tripropylenglycoldiacrylat, Hexandioldiacrylat, ethoxyliertem Trimethylolpropanacrylat, und Bisphenol-A-ethoxyliertem Acrylat.

5. Stabile flüssige Zusammensetzungen nach Anspruch 1, dadurch gekennzeichnet, daß der Acrylester Tripropylenglycoldiacrylat ist.

6. Stabile flüssige Zusammensetzungen nach Anspruch 1, dadurch gekennzeichnet, daß das Lösungsmittel a-Hydroxybutyrophenon ist.

7. Stabile flüssige Zusammensetzungen nach Anspruch 1, dadurch gekennzeichnet, daß das flüssige Benzophenon eine eutektische flüssige Mischung aus 80 Teilen 2,4,6-Trimethylbenzophenon und 20 Teilen 4-Methylbenzophenon ist.

8. Verfahren zur Herstellung flüssiger Zusammensetzungen nach Anspruch 1, dadurch gekennzeichnet, daß es die folgenden essentiellen Stufen umfaßt:
(A) Gleichzeitige Cyclisierung und Oligomerisierung einer Styrolverbindung, ausgewählt aus der Gruppe bestehend aus Styrol, a-Methylstyrol, und durch C₂-C₄-Alkylgruppen und Diphenylethylenα-substituiertes Styrol, in Gegenwart eines sauren Katalysators und in Abwesenheit eines Lösungsmittels, wobei man zwei Stufen durchführt: eine erste Stufe bei einer Temperatur von 55° bis 80 °C während 1 bis 3 Stunden, und eine zweite Stufe bei 120 °C während 1 bis 3 Stunden;
(B) Einführen von Carbonylgruppen durch Friedel-Crafts-Acylierung, indem man die Mischung der aus der Stufe (A) resultierenden Oligomeren, gelöst in einem Lösungsmittel ausgewählt aus der Gruppe bestehend aus Schwefelkohlenstoff, Methylenchlorid, Dichlorethan, 1,1,1-Trichiorethan und Chlorfluorkohlenwasserstoffen, oder Mischungen davon, mit einer Lösung eines Komplexes zwischen einem Carbonsäurechlorid und einem Lewissäure-Katalysator im gleichen Lösungsmittel bei einer Temperatur von zwischen -20 °C und +20 °C behandelt, und danach eine Hydrolyse, Waschen mit Wasser und Verdampfung des Lösungsmittels anschließt;
(C) Verdünnen der resultierenden Mischung der 1-Phenylindancarbonylderivate durch Zugabe von mindestens einem Lösungsmittel ausgewählt aus der Gruppe bestehend aus Xylol, Methylethylketon, Butylacetat, einem gegebenenfalls ethoxyliertem Acrylester eines Glycols oder eines Polyols, N-Vinylpyrrolidon, a-Hydroxyisobutyrophenon, einem flüssigen Benzophenon und Diethoxyacetophenon.

9. Verfahren nach Anspruch 8, dadurch gekennzeichnet, daß der zur Durchführung der Stufe (A) verwendete saure Katalysator ausgewählt ist aus der Gruppe bestehend aus sauren Tonen, lonenaustauschharzen mit Sulfonsäuregruppen in saurer Form, und C₁-C₁₈-Alkylsulfonsäuren und C₆-C₁₈-Arylsulfonsäuren.

10. Verfahren nach Anspruch 8, dadurch gekennzeichnet, daß der in Stufe (A) verwendete saure Katalysator in fester Form vorliegt.

## Patentansprüche (Patentansprüche für folgende(n) Vertragsstaat(en) : ES)

1. Verfahren zur Herstellung stabiler flüssiger Zusammensetzungen, die zwischen 25 und 75 Gewichtsteile mindestens eines Lösungsmittels enthalten ausgewählt aus der Gruppe bestehend aus Xylol, Methylethylketon, Butylacetat, einem gegebenenfalls ethoxylierten Acrylester eines Glycols oder eines Polyols, N-Vinylpyrrolidon, a-Hydroxyisobutyrophenon, einem flüssigen Benzophenon und Diethoxyacetophenon, und zwischen 25 und 75 Gewichtsteile mindestens eines 1-Phenylindancarbonyl-Derivats, dessen Struktur durch die Formel dargestellt wird: 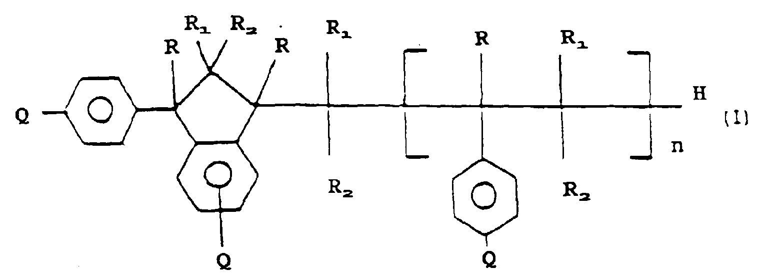 worin bedeuten:
n: 0 bis 1;
R, R_{1'} R₂: gleich oder verschiedene Reste, die unabhängig voneinander H, C₁-C₃-Alkyl bedeuten;
Q: eine Gruppe bedeutet 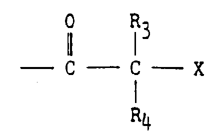 worin:
R₃, R₄ gleich oder verschieden sind und unabhängig voneinander bedeuten können:
- C₁-C₈-Alkyl,
- zusammen eine C₃-C₇-Polyalkylengruppe,
- zusammen genommen ein Sauerstoffatom;
X: kann bedeuten Cl, OH, OR, worin R die gleiche Bedeutung wie vorstehend angegeben besitzt, dadurch gekennzeichnet, daß es die folgenden essentiellen Stufen umfaßt:
(A) Gleichzeitige Cyclisierung und Oligomerisierung einer Styrolverbindung, ausgewählt aus der Gruppe bestehend aus Styrol, a-Methylstyrol, und durch C₂-C₄-Alkylgruppen und Diphenylethylen a-substituiertes Styrol, in Gegenwart eines sauren Katalysators und in Abwesenheit eines Lösungsmittels, wobei man zwei Stufen durchführt: eine erste Stufe bei einer Temperatur von 55° bis 80 °C während 1 bis 3 Stunden und eine zweite Stufe bei 120 °C während 1 bis 3 Stunden;
(B) Einführen von Carbonylgruppen durch Friedel-Crafts-Acylierung, indem man die Mischung der aus der Stufe (A) resultierenden Oligomeren, gelöst in einem Lösungsmittel ausgewählt aus der Gruppe bestehend aus Schwefelkohlenstoff, Methylenchlorid, Dichlorethan, 1,1,1-Trichlorelhan und Chlorfluorkohlenwasserstoffen, oder Mischungen davon, mit einer Lösung eines Komplexes zwischen einem Carbonsäurechlorid und einem Lewissäure-Katalysator im gleichen Lösungsmittel bei einer Temperatur von zwischen -20 °C und +20 °C behandelt, und danach eine Hydrolyse, Waschen mit Wasser und Verdampfung des Lösungsmittels anschließt;
(C) Verdünnen der resultierenden Mischung der 1-Phenylindancarbonylderivate durch Zugabe von mindestens einem Lösungsmittel ausgewählt aus der Gruppe bestehend aus Xylol, Methylethylketon, Butylacetat, einem gegebenenfalls ethoxyliertem Acrylester eines Glycols oder eines Polyols, N-Vinylpyrrolidon, a-Hydroxyisobutyrophenon, einem flüssigen Benzophenon und Diethoxyacetophenon.

2. Verfahren nach Anspruch 1, dadurch gekennzeichnet, daß der zur Durchführung der Stufe (A) verwendete saure Katalysator ausgewählt ist aus der Gruppe bestehend aus sauren Tonen, lonenaustauscherharzen mit Sulfonsäuregruppen in saurer Form, und C₁-C₁₈-Alkylsulfonsäuren und C₆-C₁₈-Arylsulfonsäuren.

3. Verfahren nach Anspruch 1, dadurch gekennzeichnet, daß der in Stufe (A) verwendete saure Katalysator in fester Form vorliegt.

4. Verfahren nach Anspruch 1, dadurch gekennzeichnet, daß die stabilen flüssigen Zusammensetzungen zwischen 30 und 70 Gewichtsteile der Derivate der Formel (I) enthalten.

5. Verfahren nach Anspruch 1, dadurch gekennzeichnet, daß das 1-Phenylindancarbonyl-Derivat zwischen 70 % und 90 Gew.-% Dimere der Formel (I), worin n=O, enthält, und der verbleibende Anteil aus Trimeren der Formel (I), worin n=₁, besteht.

6. Verfahren nach Anspruch 1, dadurch gekennzeichnet, daß der Acrylester ausgewählt ist aus der Gruppe bestehend aus Tripropylenglycoldiacrylat, Hexandioldiacrylat, ethoxyliertem Trimethylolpropanacrylat, und Bisphenol-A-ethoxyliertem Acrylat.

7. Verfahren nach Anspruch 1, dadurch gekennzeichnet, daß der Acrylester Tripropylenglycoldiacrylat ist.

8. Verfahren nach Anspruch 1, dadurch gekennzeichnet, daß das Lösungsmittel a-Hydroxybutyrophenon ist.

9. Verfahren nach Anspruch 1, dadurch gekennzeichnet, daß das flüssige Benzophenon eine eutektische flüssige Mischung aus 80 Teilen 2,4,6-Trimethylbenzophenon und 20 Teilen 4-Methylbenzophenon ist.

## Revendications (Revendications pour l'(les) Etat(s) contractant(s) suivant(s) : AT, BE, CH, LI, DE, FR, GB, NL, SE, IT)

1. Compositions liquides stables contenant entre 25 et 75 parties en poids d'au moins un solvant choisi dans le groupe consistant en xylène, méthyl éthyl cétone, acétate de butyle, ester acrylique éventuellement éthoxylé d'un glycol ou d'un polyol, N-vinyl pyrrolidone, alpha-hydroxy isobutyrophénone, benzophénone liquide et diéthoxyacétophénone et contenant entre 25 et 75 parties en poids d'au moins un dérivé de 1-phénylindane carbonyle, dont la structure est représentée par la formule (1) : 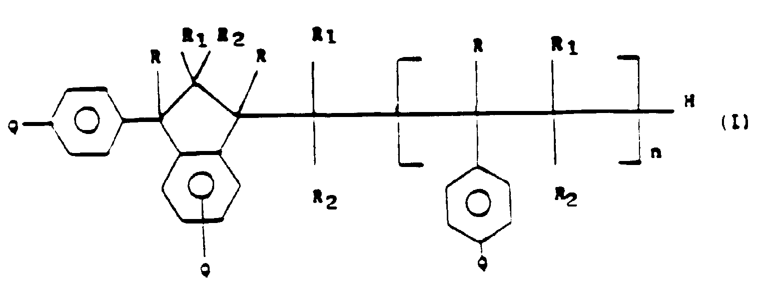 dans laquelle :
n est 0 à 1;
R, R₁, R₂ sont identiques ou différents, et représentent chacun indépendamment un atome d'hydrogène ou un groupe alkyle en C₁₋₃;
Q représente un groupe : 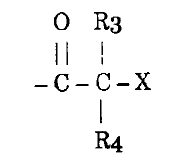 dans lequel :
R₃, R₄ identiques ou différents, peuvent être chacun de façon indépendante :
un groupe alkyle en C₁₋₈,
ils peuvent former ensemble un groupe polyalkylène en C₃₋₇,
ils peuvent coïncider ensemble en un atome d'oxygène;
X peut être Cl, OH, OR dans lequel R est tel que défini plus haut.

2. Compositions liquides stables suivant la revendication 1, contenant entre 30 et 70 parties en poids des dérivés de formule (1).

3. Compositions liquides stables suivant la revendication 1, dans lesquelles le dérivé de 1-phénylindane carbonyle contient entre 70% et 90% en poids de dimères de formule (l) dans laquelle n = O, la partie restante étant constituée par des trimères de formule (l) dans laquelle n = 1.

4. Compositions liquides stables suivant la revendication 1, dans lesquelles l'ester acrylique est choisi dans le groupe consistant en diacrylate de tripropylène glycol, diacrylate d'hexanediol, acrylate de triméthylol propane éthoxylé et acrylate de bis-phénol-A éthoxylé.

5. Compositions liquides stables suivant la revendication 1, dans lesquelles l'ester acrylique est le diacrylate de tripropylène glycol.

6. Compositions liquides stables suivant la revendication 1, dans lesquelles le solvant est l'alpha-hydroxybutyrophé- none.

7. Compositions liquides stables suivant la revendication 1, dans lesquelles la benzophénone liquide est un mélange liquide eutectique de 80 parties de 2,4,6-triméthylbenzophénone et de 20 parties de 4-méthylbenzophénone.

8. Procédé pour la préparation de compositions liquides suivant la revendication 1. comprenant les étapes essentielles suivantes :
(A) cyclisation et oligomérisation simultanées d'un composé du styrène choisi dans le groupe consistant en styrène, alpha-méthylstyrène et styrène alpha-substitué par des groupes alkyles en C₂₋₄ et diphényléthylène, en présence d'un catalyseur acide et en l'absence de solvants, effectuées en deux étapes: une première étape conduite à une température de 55°C à 80°C pendant 1 à 3 heures et une seconde étape menée à 120°C pendant 1 à 3 heures;
(B) introduction de groupes carbonyles par acylation Friedel-Crafts, au cours d'un traitement du mélange d'oligomères résultant de l'étape (A), dissous dans un solvant choisi dans le groupe consistant en sulfure de carbone, chlorure de méthylène, dichloroéthane, 1,1,1-trichloroéthane et hydrocarbures chloro-fluoro, ou mélanges de ceux-ci, avec une solution dans le même solvant d'un complexe formé entre un chlorure d'acide carboxylique et un catalyseur de type acide de Lewis à une température comprise entre -20°C et +20°C, suivi d'une hydrolyse, d'un lavage à l'eau et de l'évaporation du solvant;
(C) dilution du mélange résultant de dérivés de 1-phénylindane carbonyle par addition d'au moins un solvant choisi dans le groupe consistant en xylène, méthyl éthyl cétone, acétate de butyle, ester acrylique éventuellement éthoxylé d'un glycol ou d'un polyol, N-vinyl pyrrolidone, alpha-hydroxy isobutyrophénone, benzophénone liquide et diéthoxyacétophénone.

9. Procédé suivant la revendication 8, caractérisé en ce que le catalyseur acide utilisé pour effectuer l'étape (A) est choisi dans le groupe consistant en argiles acides, résines d'échange d'ions avec des groupes sulfoniques sous forme acide et acides alkylsulfoniques en C₁₋₁₈ et arylsulfoniques en C₆₋₁₈.

10. Procédé suivant la revendication 8, caractérisé en ce que le catalyseur acide utilisé pour effectuer l'étape (A) est sous forme solide.

## Revendications (Revendications pour l'(les) Etat(s) contractant(s) suivant(s) : ES)

1. Procédé pour la préparation de compositions liquides stables contenant entre 25 et 75 parties en poids d'au moins un solvant choisi dans le groupe consistant en xylène, méthyl éthyl cétone, acétate de butyle, ester acrylique éventuellement éthoxylé d'un glycol ou d'un polyol, N-vinyl pyrrolidone, alpha-hydroxy isobutyrophénone, benzophénone liquide et diéthoxyacétophénone et contenant entre 25 et 75 parties en poids d'au moins un dérivé de 1-phénylindan carbonyle, dont la structure est représentée par la formule (1) : 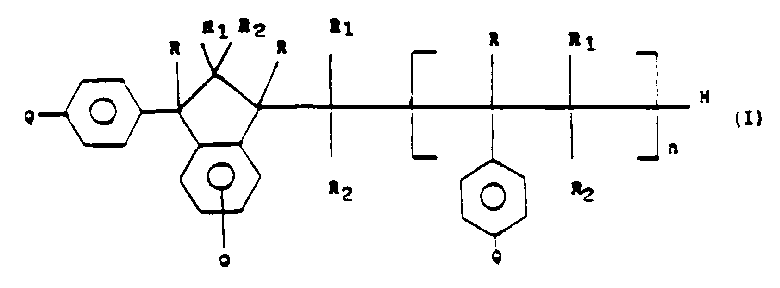 dans laquelle :
n est 0 à 1;
R, R_{1'} R₂ sont identiques ou différents, et représentent chacun indépendamment un atome d'hydrogène ou un groupe alkyle en C₁₋₃;
Q représente un groupe : 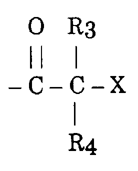 dans lequel :
R₃, R₄ identiques ou différents, peuvent être chacun de façon indépendante:
un groupe alkyle en C₁₋₈,
ils peuvent former ensemble un groupe polyalkylène en C₃₋₇,
ils peuvent coïncider ensemble en un atome d'oxygène;

X peut être Cl, OH, OR dans lequel R est tel que défini plus haut comprenant les étapes essentielles suivantes :
(A) cyclisation et oligomérisation simultanées d'un composé du styrène choisi dans le groupe consistant en styrène, alpha-méthylstyrène et styrène alpha-substitué par des groupes alkyles en C₂₋₄ et diphényléthylène, en présence d'un catalyseur acide et en l'absence de solvants, effectuées en deux étapes: une première étape conduite à une température de 55°C à 80°C pendant 1 à 3 heures et une seconde étape menée à 120°C pendant 1 à 3 heures;
(B) introduction de groupes carbonyles par acylation Friedel-Crafts, au cours d'un traitement du mélange d'oligomères résultant de l'étape (A), dissous dans un solvant choisi dans le groupe consistant en sulfure de carbone, chlorure de méthylène, dichloroéthane, 1,1,1-trichloroéthane et hydrocarbures chloro-fluoro, ou mélanges de ceux-ci, avec une solution dans le même solvant d'un complexe formé entre un chlorure d'acide carboxylique et un catalyseur de type acide de Lewis à une température comprise entre -20°C et +20°C, suivi d'une hydrolyse, d'un lavage à l'eau et de l'évaporation du solvant;
(C) dilution du mélange résultant de dérivés de 1-phénylindane carbonyle par addition d'au moins un solvant choisi dans le groupe consistant en xylène, méthyl éthyl cétone, acétate de butyle, ester acrylique éventuellement éthoxylé d'un glycol ou d'un polyol, N-vinyl pyrrolidone, alpha- hydroxy isobutyrophénone, benzophénone liquide et diéthoxyacétophénone.

2. Procédé suivant la revendication 1, caractérisé en ce que le catalyseur acide utilisé pour effectuer l'étape (A) est choisi dans le groupe consistant en argiles acides, résines d'échange d'ions avec des groupes sulfoniques sous forme acide et acides alkylsulfoniques en C₁₋₁₈ et arylsulfoniques en C₆₋₁₈.

3. Procédé suivant la revendication 1, caractérisé en ce que le catalyseur acide utilisé pour effectuer l'étape (A) est sous forme solide.

4. Procédé suivant la revendication 1, dans lequel les compositions liquides stables contiennent entre 30 et 70 parties en poids des dérivés de formule (1).

5. Procédé suivant la revendication 1, dans lequel les compositions liquides stables contiennent entre 70% et 90% en poids de dimères de formule (l) dans laquelle n 0, la partie restante étant constituée par des trimères de formule (l) dans laquelle n = 1.

6. Procédé suivant la revendication 1, dans lequel l'ester acrylique est choisi dans le groupe consistant en diacrylate de tripropylène glycol, diacrylate d'hexanediol, acrylate de triméthylol propane éthoxylé et acrylate de bis-phénol-A éthoxylé.

7. Procédé suivant la revendication 1, dans lequel l'ester acrylique est le diacrylate de tripropylène glycol.

8. Procédé suivant la revendication 1, dans lequel le solvant est l'alpha-hydroxybutyrophénone.

9. Procédé suivant la revendication 1, dans lequel la benzophénone liquide est un mélange liquide eutectique de 80 parties de 2,4,6-triméthylbenzophénone et de 20 parties de 4-méthylbenzophénone.
